## Europäisches Patentamt

## European Patent Office

## Office européen des brevets

(11) Publication number: **0 069 707**
**B1**

## (12) EUROPEAN PATENT SPECIFICATION

(45) Date of publication of patent specification: **17.09.86**

(51) Int. Cl.⁴: **H 01 L 21/316**

(21) Application number: **82830121.8**

(22) Date of filing: **07.05.82**

(54) **Method of oxidising semiconductor substrates.**

(30) Priority: **29.05.81 IT 4858181**

(43) Date of publication of application:
**12.01.83 Bulletin 83/02**

(45) Publication of the grant of the patent:
**17.09.86 Bulletin 86/38**

(84) Designated Contracting States:
**DE FR GB NL SE**

(56) References cited:

**THIN SOLID FILMS, vol. 65, no. 3, February
1980, Lausanne, S. GOURRIER et al., "Oxidation
of GaAs im an Oxygen Multipole Plasma",
pages 315 to 330**

(73) Proprietor: **SELENIA INDUSTRIE
ELETTRONICHE ASSOCIATE S.p.A.
Via Tiburtina, KM 12.400
I-00131 Roma (IT)**

(72) Inventor: **Cetronio, Antonio
Via di Villa Taverna, 28
Monteporzio I-00040 Roma (IT)**

(74) Representative: **Gustorf, Gerhard, Dipl.-Ing.
Mühlenstrasse 1
D-8300 Landshut (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 069 707 B1

## Description

The present invention relates to a method of oxidizing a semiconductor substrate by means of a gas plasma.

The formation of stable oxide layers with good characteristics on semiconductor substrates presents great interest both from the point of view of fabricating MOS type devices as well as a substrate encapsulant during thermal annealing after ion implantation.

Other oxidation procedures such as the electrolytic process with an electrolyte or the reactive plasma gas discharges yield good results on materials with relatively good electrical conductivity, however they do not lend themselves to the oxidation of semiconductor material because the latter does not allow the necessary charge movement caused by the reactive plasma oxidation. For semiconductor materials such as gallium arsenide the approach most commonly used is that of a non-native oxide deposition with all the associated inconveniences.

A method of oxidizing a semiconductor substrate by means of a gas plasma is already known from "Thin solid films", Volume 65, No. 3, pages 315 to 330. In order to generate a layer of oxide on the substrate surface, the substrate is fixed on a sample holder in a vacuum chamber. By generating a gas plasma, the desired oxide layer grows on the surface of the substrate. As described in the document mentioned above, the temperature of the semiconductor substrate is regulated so as to always be less than 100°C, because such a temperature has been regarded as being necessary for the oxide properties.

In view of this state of art, the present invention is based on the technical task of how to increase the necessary time for forming the oxide layer on the semiconductor substrate.

This technical task is solved by a method of oxidizing a semiconductor substrate in accordance with claim 1. By utilising the fact, that the resistivity of semiconductor material decreases with increasing temperature, the present invention teaches to increase the temperature of the semiconductor substrate to a level which is sufficient for reducing the resistivity thereof for allowing the necessary charge flow during the plasma oxidation.

In accordance with claim 2, gallium arsenide is to be considered as a preferred semiconductor substrate to which the proposed method can be applied. The temperature increase necessary to achieve the desired effect described, is much less than that necessary to achieve an appreciable thermal oxidation and as such does not create any decomposition problems with compound semiconductors such as gallium arsenide.

In accordance with claim 3 a temperature between 400°C and 500°C has been found to be adequate for oxidizing a substrate of gallium arsenide.

Preferably a source of r.f. power is used producing the plasma discharge for increasing the temperature of the substrate. In practice the substrate of semiconductor material is introduced into an r.f. plasma reactor by placing it — by means of a good thermal contact — onto a graphite support, which is induction heated by the same r.f. generator which produces the plasma discharge.

With the method proposed by the present invention it is possible to obtain the oxidation of a semiconductor material with a native oxide. This type of oxide is preferred to the non-native oxides because in the latter case stresses are generally introduced at the interface and the adhesion is often poor.

According to this invention the procedure can be used whenever a good quality oxide layer has to be ground on a semiconductor substrate, and in particular as two specific examples:

a) The oxide layer can be grown on the semiconductor material before ion implantation (which is carried out across the oxide) and left on the sample as an encapsulant during thermal annealing (for activating the implanted donors).

b) The oxide can be used as an insulator in a MOS (metal-oxide-semiconductor) type structure.

## Claims

1. Method of oxidizing a semiconductor substrate by means of a gas plasma, characterized by the method step of increasing the temperature of the semiconductor substrate to a temperature value which is sufficient for reducing the resistivity of the semiconductor substrate so as to enable the necessary charge flow during the plasma oxidation.

2. Method as claimed in claim 1, characterized in that the semiconductor substrate consists of gallium arsenide.

3. Method as claimed in claim 2, characterized in that the temperature is between 400°C and 500°C.

4. Method as claimed in one of the claims 1 to 3, characterized by the using of a source of r.f. power producing the plasma discharge for increasing the temperature of the substrate.

## Patentansprüche

1. Verfahren zum Oxydieren von Halbleitersubstraten mittels eines Gasplasmas, dadurch gekennzeichnet, daß das Halbleitersubstrat auf eine Temperatur erhöht wird, die ausreicht, den spezifischen Widerstand des Halbleitersubstrates so weit zu reduzieren, daß der erforderliche Ladungsfluß während der Plasma-Oxydation ermöglicht wird.

2. Verfharen nach Anspruch 1, dadurch gekennzeichnet, daß das Halbleitersubstrat aus Galliumarsenide besteht.

3. Verfahren nach Anspruch 2, dadurch gekennzeichnet, daß die Temperatur zwischen 400°C und 500°C liegt.

4. Verfahren nach einem der Ansprüche 1 bis 3, dadurch gekennzeichnet, daß ein Hochfrequenz-

Generator zur Erzeugung der Plasmaentladung verwendet wird, um die Temperatur des Substrates zu erhöhen.

## Revendications

1. Procédé pour l'oxydation d'un substrat semiconducteur au moyen d'un plasma gazeux, caractérisé par l'étape consistant à augmenter la température du substrat semiconducteur à une valeur de température suffisante pour réduire la résistivité du substrat semiconducteur de façon à permettre le courant de charge nécessaire pendant l'oxydation par plasma.

2. Procédé selon la revendication 1, caractérisé en ce que le substrat semiconducteur consiste en arséniure de gallium.

3. Procédé selon la revendication 2, caractérisé en ce que la température est comprise entre 400°C et 500°C.

4. Procédé selon l'une quelconque des revendications 1 à 3, caractérisé en ce que l'on utilise une source de puissance haute fréquence produisant la décharge de plasma pour augmenter la température du substrat.